# DEMANDE DE BREVET EUROPEEN

(11) **EP 2 211 382 A2**
(43) Date de publication de la demande: **28.07.2010**
(21) Numéro de dépôt: 09306302.2
(22) Date de dépôt: 22.12.2009
(51) Int. Cl.: H01L 23/29, H01L 23/31

(54) **Barrière étanche pour microcomposant et procédé de fabrication d'une telle barrière**

(30) Priorité: 26.01.2009 FR 0950437
(71) Demandeur: Commissariat à l'Énergie Atomique et aux Énergies Alternatives, 75015 Paris (FR)
(72) Inventeur: Sanchette, Frédéric, 38620, MONTFERRAT (FR); Ducros, Cédric, 38690, BEVENAIS (FR); Martin, Steve, 38160, SAINT SAUVEUR (FR)
(74) Mandataire: Vuillermoz, Bruno

(57) **Abrégé**

Ce procédé de fabrication d'une barrière étanche (14) pour microcomposant (10), comportant l'empilement de deux couches (16, 20) minces d'étanchéité, consiste à former une couche intercalaire fusible (18) entre les deux couches d'étanchéité (16, 20), ladite couche intercalaire fusible (18) présentant une température de fusion inférieure à celle des deux couches (16, 20) d'étanchéité, et à fondre ladite couche intercalaire (18).

## Description

### DOMAINE DE L'INVENTION

L'invention a trait au domaine de l'étanchéité de microcomposants électroniques, notamment l'encapsulation de ceux-ci pour les préserver des dommages créés par des gaz ou des fluides.

### ETAT DE LA TECHNIQUE

Dans certaines applications, les microcomposants électroniques nécessitent d'être placés sous vide afin de les protéger de gaz, tels que l'oxygène ou l'azote, ou de liquide, qui sinon les endommageraient. Il est possible de citer, entre autre, les cellules voltaïques, les diodes électroluminescente, ou encore les micro-batteries au lithium.

Une première solution efficace envisagée consiste à coller une plaque de verre massive directement sur le microcomposant électronique. Cependant cette solution n'est pas compatible avec de très petites surfaces, ne confère aucune flexibilité au microcomposant, et présente un encombrement généralement trop important pour les applications nécessitant une miniaturisation poussée.

L'apposition d'une plaque de matériau massif sur le composant étant restrictive dans le domaine de la microélectronique, des techniques de dépôt de couches minces sont généralement utilisées pour assurer les propriétés d'étanchéité recherchées. Cependant, le dépôt de couches minces, tant par les techniques de dépôt par voie physique que par les techniques de dépôt par voie chimique, ne permet pas une étanchéité parfaite. En effet, une couche mince obtenue par de telles techniques comporte usuellement des chemins de diffusion des gaz en raison des défauts de croissance de la couche propre lors de son dépôt. C'est pourquoi il est usuellement prévu dans les espaces étanchéifiés par le dépôt de couches minces des getter qui absorbent les gaz s'étant infiltrés dans ledit espace par les chemins de diffusion.

Un autre moyen de minimiser le problème né de la présence de chemins de diffusion consiste à empiler successivement plusieurs couches minces afin de découpler les défauts de croissance et ainsi rallonger les chemins de diffusion des molécules de gaz, comme cela est par exemple décrit dans les documents US 2004/023847, WO 2003/069714, WO 247187 et US 6 737 192.

Toujours dans l'objectif de minimiser le problème inhérent aux chemins de diffusion des gaz, les recherches s'orientent également sur les matériaux constitutifs des différentes couches. Ainsi par exemple, les documents cités précédemment proposent également d'alterner des couches de matériaux différents, chacun de ces documents proposant des choix particuliers de matériaux (oxyde métallique, nitrure, carbure métallique, diélectrique, époxy, céramique...).

L'étanchéité par couches minces proposée dans l'état antérieur de la technique s'avère ainsi fastidieuse et coûteuse, car elle nécessite l'emploi d'au moins une dizaine de couches pour obtenir des taux étanchéité qui sont encore quelques fois insuffisants.

### EXPOSE DE L'INVENTION

Le but de la présente invention est de proposer un procédé de fabrication d'une barrière étanche pour des microcomposants présentant une étanchéité quasi parfaite avec un minimum de couches, et cela même quand des techniques de dépôt classique sont utilisées, notamment la technique de dépôt sous vide en phase vapeur.

A cet effet l'invention a pour objet un procédé de fabrication d'une barrière étanche pour microcomposant, comportant l'empilement de deux couches mince d'étanchéité.

Selon l'invention, le procédé consiste à former une couche intercalaire fusible entre les deux couches d'étanchéité, ladite couche intercalaire fusible présentant une température de fusion inférieure à celle des deux couches d'étanchéité, et à fondre ladite couche intercalaire.

En d'autres termes, la fusion de la couche intercalaire obstrue les chemins de diffusion des couches d'étanchéité de manière efficace. Il n'est donc pas besoin de prévoir le dépôt de dizaines de couches, ni même de prévoir des combinaisons de différents matériaux pour celles-ci. Une étanchéité satisfaisante est ainsi obtenue de manière simple.

Avantageusement, la couche intercalaire fusible est réalisée en indium.

Selon une autre caractéristique avantageuse de l'invention, la couche intercalaire présente une caractéristique eutectique.

Selon encore une autre caractéristique avantageuse de l'invention, la couche intercalaire est constituée d'un bloc de matériau eutectique.

L'invention a également pour objet une barrière étanche pour microcomposant, comportant au moins un empilement deux couches minces d'étanchéité. Selon l'invention, la barrière comporte une couche intercalaire fusible entre les au moins deux couches d'étanchéité, ladite couche intercalaire fusible présentant une température de fusion inférieure à celle des deux couches d'étanchéité.

### BREVE DESCRIPTION DES FIGURES

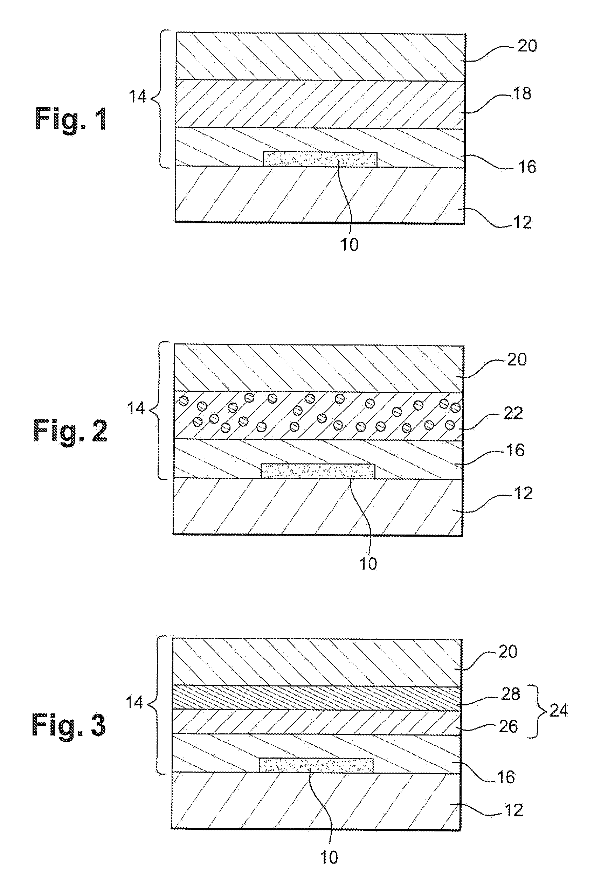

L'invention sera mieux comprise à la lecture de la description qui va suivre, donnée uniquement à titre d'exemple, et réalisée en relation avec les dessins annexés, dans lesquels :
■ la figure 1 est une vue schématique en section d'un microcomposant encapsulé par une barrière d'étanchéité selon un premier mode de réalisation selon l'invention ;
■ la figure 2 est une vue schématique en section d'un microcomposant encapsulé par une barrière d'étanchéité selon un deuxième mode de réalisation selon l'invention ;
■ la figure 3 est une vue schématique en section d'un microcomposant encapsulé par une barrière d'étanchéité selon un troisième mode de réalisation selon l'invention.

### DESCRIPTION DETAILLEE DE L'INVENTION

Sur la figure 1, un microcomposant électronique **10,** telle qu'une micro-batterie au lithium, une photodiode ou autre, est formé à la surface d'un substrat **12.**

Afin d'étanchéifier le microcomposant **10,** une barrière étanche **14** selon l'invention est réalisée. Cette barrière **14** comporte un empilement constitué :
- d'une première couche d'étanchéité **16,** déposée à la surface du microcomposant **10,** de manière à recouvrir celui-ci,
- d'une couche intercalaire fusible **18** déposée sur la première couche **16,**
- et d'une deuxième couche d'étanchéité déposée sur la couche intercalaire **18** de sorte que cette dernière est prise en sandwich entre les couches d'étanchéité **16** et **20.**

Chacune des couches **16, 18, 20** est par exemple obtenue successivement par une technique classique de dépôt sous vide en phase vapeur par voie physique ou chimique, telle que PVD (« *Physical Vapor Deposition* ») ou CVD (« *Chemical Vapor deposition* »).

Le matériau constitutif de la couche intercalaire fusible **18** est choisi de telle sorte que sa température de fusion soit inférieure à la température de fusion des couches d'étanchéité **16** et **20** et inférieure à la température de stabilité du substrat **10.**

De préférence, les couches d'étanchéité **16** et **20** sont constituées d'un matériau présentant une température de fusion élevée, comme par exemple de l'alumine (Al₂O₃) dont la température de fusion est de 2000°C

Ainsi, après avoir réalisé l'empilement des couches **16, 18** et **20,** l'objet ainsi obtenu est soumis à une chauffage entraînant la fusion de la couche intercalaire **18,** sans pour autant entraîner celle des couches **16** et **20** ou endommager le substrat **12** et le composant **10.** Par exemple, le traitement thermique est réalisé directement dans l'enceinte mise en oeuvre pour réaliser le dépôt sous vide de l'empilement des couches **16, 18** et **20.**

Le matériau en fusion de la couche intercalaire **18** colmate alors les porosités des couches **16** et **20** présentes de par les défauts de croissance inhérents aux techniques de dépôt utilisées pour réaliser les couches **16, 18** et **20.**

Dans une première variante de l'invention, la couche intercalaire **16** est constituée en un unique matériau à la température de fusion basse, tel que par exemple de l'indium qui présente une température de fusion de 157 °C.

Dans une seconde variante de l'invention, la couche intercalaire **16** est réalisée en un matériau eutectique présentant un point de fusion bas, notamment un matériau eutectique choisi parmi les alliages suivants :
■ alliage d'étain et d'indium, notamment dans des proportions respectives de 48% et 52% en poids, l'alliage dans de telles proportions ayant une température de fusion de 120°C ;
■ alliage d'étain et de bismuth, notamment dans des proportions respectives de 42% et 58% en poids, l'alliage dans de telles proportions ayant une température de fusion de 139°C ;
■ alliage d'étain, de plomb et de cadmium, notamment dans des proportions respectives de 50%, 32% et 18% en poids, l'alliage dans de telles proportions ayant une température de fusion de 145°C ;
■ alliage d'indium, de plomb et d'argent, notamment dans des proportions respectives de 80%, 15% et 5% en poids, l'alliage dans de telles proportions ayant une température de fusion de 149°C ;
■ alliage d'étain, de plomb et d'argent, notamment dans des proportions respectives de 62%, 36% et 2% en poids, l'alliage dans de telles proportions ayant une température de fusion de 178°C ;
■ alliage d'étain et de plomb, notamment dans des proportions respectives de 63% et 37% en poids, l'alliage dans de telles proportions ayant une température de fusion de 183°C ;
■ alliage d'étain, de plomb et d'antimoine, notamment dans des proportions respectives de 63%, 36,7% et 0,3% en poids, ou dans des proportions respectives de 60%, 39,7% et 0.3% en poids, l'alliage dans de telles proportions ayant une température de fusion de 183°C et 188°C respectivement ;
■ alliage d'or et d'étain, notamment dans des proportions respectives de 80% et 20% en poids, l'alliage dans de telles proportions ayant une température de fusion de 280°C ;
■ alliage de plomb, d'étain et d'or, notamment dans des proportions respectives de 93,5%, 5% et 1,5% en poids, l'alliage dans de telles proportions ayant une température de fusion de 301°C ; et
■ alliage de bismuth, de cadmium, de plomb et d'étain, notamment dans des proportions respectives de 50%, 12,5%, 25% et 12,5% en poids, l'alliage dans de telles proportions ayant une température de fusion de 47°C.

Selon un deuxième mode de réalisation de l'invention illustré à la figure 2, la couche intercalaire **22,** formée entre les couches d'étanchéité **16** et **20,** est constituée d'un matériau composite, comme par exemple des particules solides d'un premier matériau participant à la formation d'un eutectique, noyées dans une matrice solide d'un second matériau participant à la formation d'un eutectique, ce matériau composite formant un eutectique ayant une température de fusion inférieure aux températures de fusion des couches **16** et **20** et de stabilité du substrat **12.**

Selon ce second mode de réalisation, les premier et second matériaux peuvent être choisis dans la liste précédemment mentionnée. L'eutectique se forme ainsi généralement aux interfaces entre les matériaux formant particule et le matériau formant la matrice.

Dans un troisième mode de réalisation de l'invention illustré à la figure 3, la couche intercalaire **24** formée entre les couches d'étanchéité **16** et **20** est constituée d'une bicouche comprenant une première sous-couche **26** d'un premier matériau et une deuxième sous-couche **28** d'un second matériau, les sous-couches **26** et **28** pouvant présenter des phases différentes. Les premier et second matériaux peuvent être choisis dans la liste précédemment mentionnée.

Ces sous-couches **26** et **28** forment entre elles un eutectique ayant une température de fusion inférieure aux températures de fusion des couches **16** et **20** et de stabilité du substrat **12.** L'eutectique se forme alors à l'interface des sous-couches **26** et **28.**

Ce troisième mode de réalisation peut constituer une alternative facile de mise en oeuvre en lieu et place du premier mode de réalisation dans le cas où les alliages seraient difficiles à obtenir.

Grâce à l'invention, il est ainsi obtenu une barrière d'étanchéité efficace en seulement trois couches, bien que plusieurs empilements tels que décrits précédemment soient envisageables en fonction des applications visées. Il peut notamment être envisagé d'avoir plus d'une couche intercalaire fusible.

Selon un développement de l'invention, la formation de la couche intercalaire **18** peut être réalisée in situ à partir d'un eutectique formé à l'interface des couches **16** et **20** par traitement thermique. Bien entendu, les matériaux constitutifs desdites couches **16** et **20** sont avantageusement sélectionnés de manière à pouvoir former un eutectique, dont la température de fusion est inférieure à chacune de celle des deux matériaux, tels que l'or et l'étain.

Le procédé de fabrication d'une barrière étanche selon l'invention est ainsi particulièrement adapté à l'encapsulation de circuit électronique, tel que des micro-batteries au lithium par exemple.

En outre, il n'est pas besoin de faire appel à des matériaux spécifiques pour les couches d'étanchéité **16** et **20** pour assurer l'étanchéité. Le choix des matériaux constitutifs de ces couches est alors plus libre et celles-ci peuvent se voir assigner des fonctions supplémentaires autre qu'une barrière contre la diffusion de gaz, telles qu'une fonction de barrière thermique, une fonction de protection contre les sollicitations mécaniques et d'enveloppe de protection ou encore une fonction d'isolation électrique.

De manière avantageuse, l'alumine est ainsi choisie pour former les couches **16** et **20** en raison de sa haute température de fusion, comme cela a été décrit précédemment, mais également en raison de sa dureté élevée (l'alumine ayant une dureté de 20 giga pascals), et de sa caractéristique d'isolant électrique et de protecteur thermique. L'alumine peut être synthétisée en mode réactif par évaporation ou pulvérisation du titane dans une atmosphère contenant de l'oxygène, soit directement par évaporation ou pulvérisation du composé, tel que décrit dans la littérature (par exemple Alain BILLARD, Frédéric PERRY « Pulvérisation cathodique magnétron » - Techniques de l'ingénieur, M1 654).

Ainsi, et dans la cadre de la réalisation de l'encapsulation d'une micro-batterie au Lithium, on met en oeuvre les étapes suivantes :
- transfert de ladite micro-batterie dans une chambre ou enceinte d'encapsulation, avec maintien sous vide secondaire de ladite micro-batterie ;
- décapage ionique par bombardement ionique, pour aboutir à un conditionnement de la dernière couche ou couche supérieure de la micro-batterie ;
- dépôt de la première couche d'étanchéité, en l'espèce en alumine par PVD ou CVD ;
- dépôt de la couche intercalaire fusible, tel que par évaporation d'indium ;
- dépôt de la seconde couche d'étanchéité en alumine, également par PVD ou CVD ;
- éventuelle remontée à la pression atmosphérique ;
- recuit in situ sous vide secondaire à 170 °C, pour induire la fusion de la couche intercalaire d'indium.

## Revendications

1. Procédé de fabrication d'une barrière étanche (14) pour microcomposant (10), comportant l'empilement de deux couches (16, 20) minces d'étanchéité, ***caractérisé* en ce qu'**il consiste à former une couche intercalaire fusible (18 ; 22 ; 24) entre les deux couches d'étanchéité (16, 20), ladite couche intercalaire fusible (18 ; 22 ; 24) présentant une température de fusion inférieure à celle des deux couches (16, 20) d'étanchéité, et à fondre ladite couche intercalaire (18 ; 22 ; 24).

2. Procédé de fabrication d'une barrière étanche (14) pour microcomposant (10) selon la revendication 1, ***caractérisé* en ce que** la couche intercalaire (18) est réalisé en indium.

3. Procédé de fabrication d'une barrière étanche (14) pour microcomposant (10) selon la revendication 1, ***caractérisé* en ce que** la couche intercalaire (18 ; 22 ; 24) présente une caractéristique eutectique.

4. Procédé de fabrication d'une barrière étanche (14) pour microcomposant (10) selon la revendication 3, ***caractérisé*** la couche intercalaire (18 ; 22 ; 24) est constituée d'un matériau, choisi parmi les alliages suivants :
■ alliage d'étain et d'indium, notamment dans des proportions respectives de 48% et 52% en poids ;
■ alliage d'étain et de bismuth, notamment dans des proportions respectives de 42% et 58% en poids ;
■ alliage d'étain, de plomb et de cadmium, notamment dans des proportions respectives de 50%, 32% et 18% en poids ;
■ alliage d'indium, de plomb et d'argent, notamment dans des proportions respectives de 80%, 15% et 5% en poids ;
■ alliage d'étain, de plomb et d'argent, notamment dans des proportions respectives de 62%, 36% et 2% en poids ;
■ alliage d'étain et de plomb, notamment dans des proportions respectives de 63% et 37% en poids ;
■ alliage d'étain, de plomb et d'antimoine, notamment dans des proportions respectives de 63%, 36,7% et 0,3% en poids, ou dans des proportions respectives de 60%, 39,7% et 0.3% en poids ;
■ alliage d'or et d'étain, notamment dans des proportions respectives de 80% et 20% en poids ;
■ alliage de plomb, d'étain et d'or, notamment dans des proportions respectives de 93,5%, 5% et 1,5% en poids ; et
■ alliage de bismuth, de cadmium, de plomb et d'étain, notamment dans des proportions respectives de 50%, 12,5%, 25% et 12,5% en poids.

5. Procédé de fabrication d'une barrière étanche (14) pour microcomposant (10) selon l'une des revendications 3 et 4, ***caractérisé* en ce que** la couche intercalaire (18) est constituée d'un bloc de matériau eutectique.

6. Procédé de fabrication d'une barrière étanche (14) pour microcomposant (10) selon l'une des revendications 3 et 4, ***caractérisé* en ce que** la couche intercalaire (22) est réalisée en un matériau composite constitué de deux matériaux.

7. Procédé de fabrication d'une barrière étanche (14) pour microcomposant (10) selon l'une des revendications 3 et 4, ***caractérisé* en ce que** la couche intercalaire (24) est réalisée en un matériau bicouche de deux matériaux.

8. Barrière étanche (14) pour microcomposant (10), comportant au moins un empilement deux couches minces d'étanchéité (16, 20), ***caractérisée* en ce qu'**elle comporte une couche (18 ; 22 ; 24) intercalaire fusible entre les au moins deux couches d'étanchéité (16, 20), ladite couche (18 ; 22 ; 24) intercalaire fusible présentant une température de fusion inférieure à celle des deux couches (16, 20) d'étanchéité.
